# EUROPÄISCHE PATENTSCHRIFT

(11) **EP 0 521 020 B1**
(45) Veröffentlichungstag und Bekanntmachung des Hinweises auf die Patenterteilung: **26.10.1994**
(21) Anmeldenummer: 91905783.6
(22) Anmeldetag: 14.03.1991
(51) Int. Cl.: H05K 7/14

(54) **HALTEEINRICHTUNG FÜR STECKKARTEN**
HOLDING DEVICE FOR INSERT CARDS
DISPOSITIF DE RETENUE POUR CARTES EMBROCHABLES

(30) Priorität: 20.03.1990 DE 9003253 U
(43) Veröffentlichungstag der Anmeldung: 07.01.1993
(73) Patentinhaber: Siemens Nixdorf Informationssysteme Aktiengesellschaft, 33102 Paderborn (DE)
(72) Erfinder: BAITZ, Günter, D-1000 Berlin 27 (DE)
(74) Vertreter: Fuchs, Franz-Josef, Dr.-Ing.
(86) Internationale Anmeldenummer: EP9100477
(87) Internationale Veröffentlichungsnummer: WO9115102

(56) Entgegenhaltungen:
- EP-A- 282 637
- DE-U- 8 628 199
- US-A- 4 745 524
- IBM TECHNICAL DISCLOSURE BULLETIN, Bd. 30,Nr.06, November 1987,New York,US;Seiten 301-302; "Contact pressure device for personal computers"

## Beschreibung

Die Erfindung betrifft eine Halteeinrichtung für Steckkarten eines elektrischen Geräts mit einem ein rahmenartiges Steckanschlußfeld und/oder Bedienfeld bildenden Baugruppenträger, an dem die Steckkarten mittels an einer ihrer Kanten vorgesehener Blenden parallel zueinander befestigt sind, wobei jede Blende mindestens einen Steckverbinder und/oder ein Bedien- bzw. Anzeigeelement trägt, der bzw. das im Bereich eines durch die jeweilige Blende verschlossenen Durchbruchs des Baugruppenträgers angeordnet ist. Eine Halteeinrichtung dieser Art kann PC-Format haben.

In jüngerer Zeit werden die wesentlichsten Grundbaugruppen von Personal Computern wie Rechner, Speicher und Ein-/Ausgabe-Schnittstellen zur Herstellung von Steuerrechnern für Spezialzwecke benutzt. Diese Baugruppen sind auf sogenannten Steckkarten mit standardisierten Abmessungen angeordnet. Die elektrische Verbindung der Steckkarten untereinander erfolgt über ebenfalls standardisierte Steckverbindungen.

Die elektrische Verbindung der Steckkarten zur Außenwelt (Bildschirm, Tastatur, Leitungsverbindungen) oder die Gerätebedienung erfolgt über eine an einer Kante der Steckkarte angeordnete Blende, auf der Anschlußstecker angeordnet sind und die in ihren Abmessungen ebenfalls festgelegt ist. Lediglich die verwendeten Stecker - die sogenannten Peripheriestecker - sind frei wählbar. Die Peripheriestecker oder auch Bedien- und Anschlußelemente ragen durch dafür vorgesehene Druchbrüche im Baugruppenträger und bilden so dessen Anschlußfeld oder Bedienfeld. Die Länge und Breite der Durchbrüche sowie deren Lage zueinander ist ebenfalls standardisiert.

Es liegt nun nahe, die für die oben genannten Spezialanwendungen benötigte Steuerelektronik ebenfalls auf Steckkarten im PC-Format aufzubauen, da ohnehin für die PC-spezifischen Grundbaugruppen ein PC-Baugruppenträger benötigt wird.

Durch die Verwendung von Standard-PC-Elementen und - Abmessungen auch für Spezialsteuerungen ergibt sich nun aber die Gefahr, daß ein Anwender sich nur die Steckkarten mit der Spezialelektronik beschafft und diese in einem marktgängigen PC verwendet. Der Hersteller der Spezialsteuerungen wird dann um den Lohn seiner Anstrengungen gebracht, die er aufgewendet hat, die gesamte Steuerung und nicht nur die Spezialelektronik den speziellen Gegebenheiten anzupassen.

Es ist Aufgabe der Erfindung eine Halteeinrichtung anzugeben, in die wahlweise Standard-PC- und Spezialsteckkarten einsteckbar sind, wobei letztere nur in dieser Halteeinrichtung verwendbar sein sollen.

Die Aufgabe wird bei einer Halteeinrichtung eingangs genannter Art dadurch gelöst, daß mindestens ein Durchbruch größer als die übrigen Durchbrüche bemessen ist, und daß die für diesen Durchbruch vorgesehene Blende in einem gegenüber den anderen Durchbrüchen vergrößerten Abschnitt ihres Durchbruchs mindestens einen Steckverbinder und/oder ein Bedien- bzw. Anzeigeelement trägt.

Durch diese Maßnahmen wird es unmöglich, eine Steckkarte mit einer Spezialelektronik in einem Standard-PC zu verwenden, ohne zuvor dessen Baugruppenträger mechanisch zu verändern. Die Begrenzungen der Standarddurchbrüche überdecken dann nämlich die versetzt angeordneten Bauelemente wenigstens teilweise, so daß diese nicht nutzbar sind bzw. Gegenstecker nicht eingesteckt werden können.

In einer Fortbildung der Erfindung ist die für den vergrößerten Durchbruch vorgesehene Blende gegenüber dem Baugruppenträger zurückversetzt, und die Blende trägt mindestens einen Steckverbinder, dessen Gegensteckverbinder größer als die lichte Größe der nicht vergrößerten Durchbrüche ist. Dadurch kann der Gegen-Steckverbinder nicht durch einen Standard-Durchbruch gesteckt werden.

Bei der vorgenannten Fortbildung ist es vorteilhaft, wenn die Ränder der Blende aufgekantet sind und am Baugruppenträger anliegen. Dadurch wird eine lückenlose Abschirmung gegen elektromagnetische Ein- oder Aus- strahlungen sichergestellt.

In einer anderen Fortbildung ist der gegenüber den übrigen Durchbrüchen größere Durchbruch in einem die Vergrößerung erzeugenden Abschnitt durch ein Begrenzungsteil verschließbar. Mit letzterem wird es möglich, in Längsrichtung vergrößerte Durchbrüche in Standarddurchbrüche zu verwandeln. Ein Vorteil dieser Maßnahme ist darin zu sehen, daß für unterschiedliche Anwendungen ein einziger Baugruppenträger verwendet werden kann. Eine Anpassung an die Zahl der Standard-PC- und der Spezialsteckkarten wird dann nur durch die Verwendung unterschiedlicher Begrenzungsteile erreicht.

Im foglenden wird die Erfindung an Hand der Zeichnung erläutert. Darin zeigen:
- Figur 1: das Anschlußfeld eines Baugruppenträgers mit Standard- und Spezialsteckkarten als Ausführungsbeispiel und
- Figur 2: eine Doppelsteckkarte für eine Registrierkasse.

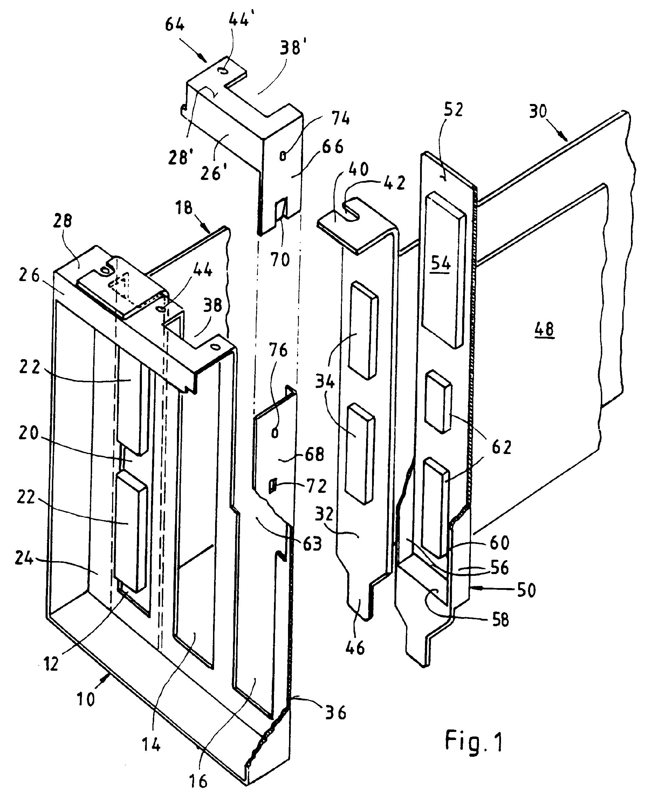

In Figur 1 ist nur das Anschlußfeld 10 eines mit drei Steckplätzen versehenen Baugruppenträgers gezeigt. Das Anschlußfeld 10 hat zwei Standarddurchbrüche 12, 14 und einen vergrößerten Durchbruch 16.

Der erste Steckplatz ist mit einer Steckkarte 18 mit Standardblende 20 bestückt. Die Blende 20 trägt Stecker 22, die durch den Durchbruch 12 hindurchragen. Auf diese sind nicht dargestellte Gegenstecker aufsteckbar.

Der zweite Steckplatz ist unbestückt. Es ist deutlich zu erkennen, daß sein Standarddurchbruch 14 unten und seitlich durch die Wand 24 des Anschlußfeldes 10 begrenzt wird. Oben ist der Durchbruch 14 durch eine parallel zur Wand 24 verlaufende Leiste 26 begrenzt. Diese ist über eine Fläche 28 mit der Wand 24 verbunden.

Eine auf den zweiten Steckplatz steckbare Steckkarte ist mit 30 bezeichnet. An ihrer einen Schmalseite trägt sie eine Standardblende 32, die mit zwei Steckern 34 bestückt ist. Die Steckkarte 30 wird von oben so in den Baugruppenträger eingeschoben, daß die Blende an der Innenseite 36 des Anschlußfeldes 10 entlanggleitet. Dabei gleiten die über die Blende 32 vorstehenden Stekker 34 durch eine Ausnehmung 38 in der Fläche 28 in den Durchbruch 14. Die andere Schmalseite der Steckkarte wird dabei in einer Nut geführt. Die Steckkarte 30 wird nun so weit in den Baugruppenträger hineingeschoben, bis eine obere Abkröpfung 40 auf der Fläche 28 zu liegen kommt. Ein Schlitz 42 läßt dabei ein Gewindeloch 44 in der Fläche 28 frei. Die Steckkarte 30 ist mittels einer Schraube, die in das Gewindeloch 44 gedreht werden kann, an ihrem Steckplatz fixierbar.

In der voll eingesteckten Stellung der Steckkarte 30 kontaktiert die Blende 32 mit einer an ihrem unteren Ende angeformten Kontaktzunge 46 in bekannter und deshalb nicht dargestellter Weise mit einem Massekontakt des Baugruppenträgers, so daß auch die Blende 32 auf Massepotential liegt. Die Kontaktzunge 46 dient dabei gleichzeitig der Zentrierung der an der Unterseite der Steckkarte befindlichen nicht dargestellten Steckkontakte gegenüber den Gegensteckern des Baugruppenträgers.

Die Leiste 26 begrenzt nicht den Durchbruch 16 des dritten Steckplatzes. Dieser Durchbruch ist also oben offen. Er erlaubt damit das Einstecken einer Steckkarte 48 mit einer verlängerten Blende 50.

Im oberen Bereich der Blendenvorderfläche 52 ist ein Stecker 54 angeordnet. Es ist zu erkennen, daß dieser Stecker, würde die Steckkarte 48 beispielsweise auf den zweiten Steckplatz gesteckt, von der Leiste 26 verdeckt würde. Der Stecker 54 ist also nur an solchen Steckplätzen kontaktierbar, an denen die Leiste 26 ausgespart ist.

Die Ränder der Blende 50 sind mit Aufkantungen 56, 58 versehen. Bei dieser Blendenform liegen die Stirnflächen 60 der Aufkantungen an der Innenseite 36 des Anschlußfeldes 10, so daß die Blendenvorderfläche 52 in einem durch die Höhe der Aufkantungen vorgegebenen Abstand gegenüber dem Anschlußfeld zurückliegt. Die Stekker 54, 62 liegen in der durch die Aufkantungen gebildeten Mulde, durchdringen als im Gegensatz zu den Stekkern 22 der Steckkarte 18 ihren Durchbruch nicht. Die auf die Stecker 54, 62 aufzusteckenden Gegenstecker müssen also schmaler sein als die lichte Breite des Durchbruchs 16. Bei den schmalen Steckern 62 ist dies sicher kein Problem, der Stecker 54 ist aber wesentlich breiter. Damit ein Gegenstecker für ihn durch den Durchbruch 16 hindurchtreten kann, ist letzterer in seinem oberen Bereich 63 verbreitert. Würde man eine Steckkarte mit einer zurückgesetzten Blendenvorderfläche wie bei der Blende 50 auf einen Steckplatz mit einem schmalen Standarddurchbruch stecken, so wäre der Stecker 54 nicht kontaktierbar.

Mit Hilfe eines Begrenzungsteils 64 ist der Durchbruch 16 in einen Standarddurchbruch verwandelbar. Das Begrenzungsteil weist eine Leiste 26′, eine Fläche 28′ mit einer Bohrung 44′ und eine Ausnehmung 38′ auf, so daß alle Führungs- und Befestigungsmittel für eine Standard-PC-Steckkarte vorhanden sind.

Das Begrenzungsteil 64 hat seitlich einen Lappen 66, mit dessen Hilfe das Begrenzungsteil 64 an einer Seitenwand 68 des Anschlußfeldes 10 befestigbar ist. Befindet sich das Teil 64 in seiner richtigen Position am Anschlußfeld 10, so greift ein am Lappen 66 durch Pressen ausgeformter Vorsprung 70 in eine Ausnehmung 72 in der Seitenwand 68, und eine Bohrung 74 im Lappen 66 deckt sich mit einem Gewindeloch 76 in der Seitenwand 68. Beide Teile können nun mit einer Schraube miteinander verbunden werden. Selbstverständlich kann auch ein Begrenzungsteil für mehrere Durchbrüche hergestellt werden.

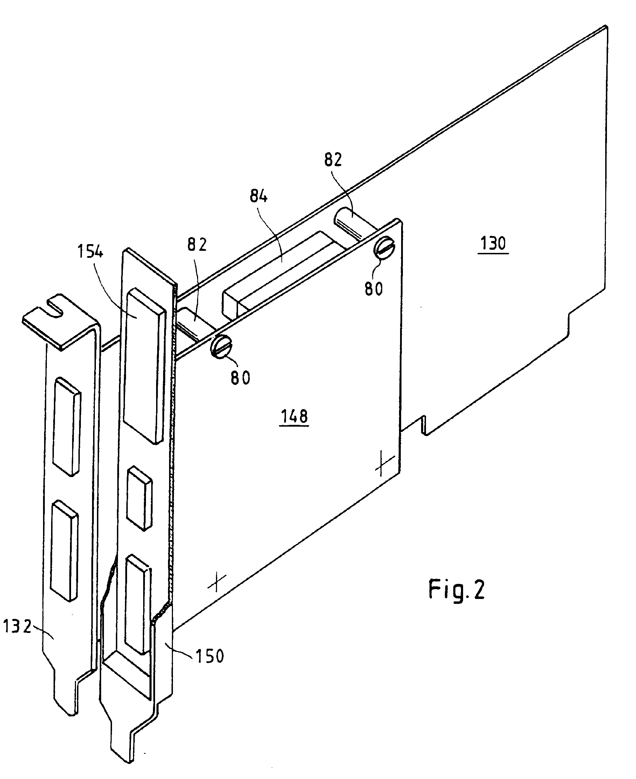

Figur 2 zeigt die Ausgestaltung einer Spezialsteckkarte mit zwei Blenden, von denen die eine als Standardblende 132 und die andere als Spezialblende 150 ausgebildet ist. Die Standardblende 132 ist an der Stirnseite einer Steckkarte 130 mit Standard-PC-Format und die Spezialblende 150 an einer Leiterplatte 148 mit Sonderformat befestigt.

Die Leiterplatte 148 ist auf der Steckkarte 130 mit Gewindebolzen 80 so befestigt, daß beide Karten parallel zueinander liegen. Der Abstand zwischen ihnen wird durch Distanzbuchsen 82 bestimmt und entspricht dem Abstand zwischen zwei benachbarten Durchbrüchen 14, 16 im Anschlußfeld 10 (Figur 1). Die elektrische Verbindung zwischen den Karten wird über ein Stecker-Buchsenleistenpaar 84 direkt hergestellt.

Die Anordnung nach Figur 2 ist besonders geeignet für die Verwendung in elektronischen Registierkassen. In der Kassensteuerung ist dann ein Baugruppenträger mit einem Anschlußfeld 10 wie in Figur 1 angeordnet. Auf dem ersten Steckplatz mit dem Durchbruch 12 befindet sich eine Standard-PC-Rechner-Speicherkarte. Die Leiterplattenkombination 130, 148 belegt die Steckplätze mit den Durchbrüchen 14 und 16 (Figur 1).

Auf der Steckkarte 130 ist die Steuerelektronik für PC-typische Pheripherieverbindungen wie Datenfernübertragung, Tastatur, Bildschirm angeordnet. Da diese Steuerelektroniken nicht kassenspezifisch sind, trägt diese Steckkarte auch eine Standardblende. Auf der Leiterplatte 148 sind kassenspezifische Steuerschaltungen angeordnet. Zu diesen gehören die Steuerschaltungen für die Geldlade, Strichcodeleser, Rückgeldgeber und Kassendrucker. Diese Sonderfunktionssteuerungen sollen nur dem Benutzer einer Registierkassen-Zentraleinheit zugänglich sein, nicht aber dem Besitzer eines Standard-PC. Aus diesem Grunde ist die Leiterplatte 148 mit der Spezialblende 150 ausgestattet. Liegen auf dem Stecker 154 beispielsweise die Anschlüsse für die Geldlade und den Kassendrucker, so sind diese Geräte nicht anschließbar, wenn sich die Leiterplatte 184 auf einem Steckplatz mit Standarddurchbruch befindet.

## Patentansprüche

1. Halteeinrichtung für Steckkarten eines elektrischen Geräts mit einem ein rahmenartiges Steckanschlußfeld und/oder Bedienfeld bildenden Baugruppenträger, an dem die Steckkarten mittels an einer ihrer Kanten vorgesehener Blenden parallel zueinander befestigt sind, wobei jede Blende mindestens einen Steckverbinder und/oder ein Bedien- bzw. Anzeigeelement trägt, der bzw. das im Bereich eines durch die jeweilige Blende verschlossenen Durchbruchs des Baugruppenträgers angeordnet ist, dadurch **gekennzeichnet,** daß mindestens ein Durchbruch (16) größer als die übrigen Durchbrüche (12,14) bemessen ist, und daß die für diesen Durchbruch (16) vorgesehene Blende (50) in einem gegenüber den anderen Durchbrüchen vergrößerten Abschnitt ihres Durchbruchs (16) mindestens einen Steckverbinder (54) und/oder ein Bedien- bzw. Anzeigeelement trägt.

2. Halteeinrichtung nach Anspruch 1, dadurch **gekennzeichnet,** daß die für den vergrößerten Durchbruch (16) vorgesehene Blende (50) gegenüber dem Baugruppenträger zurückversetzt ist und daß die Blende (50) mindestens einen Steckverbinder (54) trägt, dessen Gegensteckverbinder größer als die lichte Größe der nicht vergrößerten Durchbrüche (12, 14) ist.

3. Halteeinrichtung nach Anspruch 2, dadurch **gekennzeichnet,** daß die Ränder (56,58) der Blende (50) aufgekantet sind und am Baugruppenträger (10) anliegen.

4. Halteeinrichtung nach einem der vorhergehenden Ansprüche, dadurch **gekennzeichnet,** daß der gegenüber den übrigen Durchbrüchen (12,14) größere Durchbruch (16) in einem die Vergrößerung erzeugenden Abschnitt durch ein Begrenzungsteil (64) verschließbar ist.

5. Halteeinrichtung nach Anspruch 4, dadurch **gekennzeichnet,** daß das Begrenzungsteil (64) einen Umfangsabschnitt des rahmenartigen Baugruppenträgers (10) bildet.

## Claims

1. Holding device for plug-in cards of an electrical device comprising a card rack forming a frame-like plug-in connection panel and/or operating panel, on which the plug-in cards are mounted in parallel with one another by means of front plates provided at one of their edges, each front plate carrying at least one plug-in connector and/or one operating or display element which is arranged in the area of an aperture of the card rack closed by the respective front plate, characterized in that at least one aperture (16) is dimensioned to be larger than the remaining apertures (12, 14) and in that the front plate (50) provided for this aperture (16) carries at least one plug-in connector (54) and/or one operating or display element in a section of its aperture (16) which is enlarged compared with the other apertures.

2. Holding device according to Claim 1, characterized in that the front plate (50) provided for the enlarged aperture (16) is set back compared with the card rack and in that the front plate (50) carries at least one plug-in connector (54), the counter plug-in connector of which is larger than the internal size of the non-enlarged apertures (12, 14).

3. Holding device according to Claim 2, characterized in that the edges (56, 58) of the front plate (50) are bent up and rest against the card rack (10).

4. Holding device according to one of the preceding claims, characterized in that the aperture (16) which is larger compared with the remaining apertures (12, 14) can be closed by a limiting part (64) in a section creating the enlargement.

5. Holding device according to Claim 4, characterized in that the limiting part (64) forms a circumferential section of the frame-like card rack (10).

## Revendications

1. Dispositif de retenue des cartes enfichables d'un appareil électrique, comportant un support de modules, qui forme un tableau de bornes à enfichage et/ou un tableau de commande en forme de cadre et sur lequel les cartes enfichables sont fixées parallèlement entre elles au moyen de panneaux prévus sur leurs bords, chaque panneau portant au moins un connecteur et/ou un élément de commande ou d'affichage, qui est disposé dans la région d'un passage, fermé par le panneau, du support de modules, caractérisé par le fait qu'au moins un passage (16) a des dimensions supérieures aux autres passages (12,14), et que le panneau (50) prévu pour ce passage (16) porte, dans une partie de son passage (16), agrandie par rapport aux autres passages, au moins un connecteur (54) et/ou un élément de commande ou d'affichage.

2. Dispositif de retenue suivant la revendication 1, caractérisé par le fait que le panneau (50), qui est prévu pour le passage (16) plus grand, est en retrait par rapport au support de modules et que le panneau (50) porte au moins un connecteur (54), dont le connecteur antagoniste est plus grand que la dimension intérieure des passages non élargis (12,14).

3. Dispositif de retenue suivant la revendication 2, caractérisé par le fait que les bords (56, 58) du panneau (50) sont placés de chant et s'appliquent au support (10) de modules.

4. Dispositif de retenue suivant l'une des revendications précédentes, caractérisé par le fait que le passage (16), plus grand que les autres passages (12,14), peut être fermé par une pièce de terminaison (64), dans une section produisant un élargissement.

5. Dispositif de retenue suivant la revendication 4, caractérisé par le fait que la pièce de terminaison (64) forme une partie faisant tout le tour du support (10) de modules en forme de cadre.
